# EUROPÄISCHE PATENTSCHRIFT

(11) **EP 3 256 861 B1**
(45) Veröffentlichungstag und Bekanntmachung des Hinweises auf die Patenterteilung: **18.03.2020**
(21) Anmeldenummer: 16700648.5
(22) Anmeldetag: 15.01.2016
(51) Int. Cl.: G01P 1/02, G01P 3/488, G01P 3/487

(54) **SENSORGEHÄUSE FÜR EINE RADSENSORVORRICHTUNG, RADSENSORVORRICHTUNG UND DEREN ANBINDUNGSKOMPONENTE**
SENSOR HOUSING FOR A WHEEL SENSOR DEVICE, WHEEL SENSOR DEVICE UND CONNECTING COMPONENT THEREOF
BOÎTIER DE CAPTEUR POUR UN DISPOSITIF CAPTEUR DE VITESSE DE ROUE, DISPOSITIF CAPTEUR DE VITESSE DE ROUE ET SON COMPOSANT DE RACCORDEMENT

(30) Priorität: 10.02.2015 DE 102015202333
(43) Veröffentlichungstag der Anmeldung: 20.12.2017
(73) Patentinhaber: Robert Bosch GmbH, 70442 Stuttgart (DE)
(72) Erfinder: WELSCH, Wolfgang, 69121 Heidelberg (DE); TEPASS, Bernd, 71717 Beilstein (DE); HAHN, Oliver, 74199 Obergruppenbach (DE); SCHEER, Mirko, 74354 Besigheim (DE); REMUS, Robert, 74395 Mundelsheim (DE)
(86) Internationale Anmeldenummer: PCT/EP2016/050802
(87) Internationale Veröffentlichungsnummer: WO 2016/128175

(56) Entgegenhaltungen:
- DE-A1- 10 041 989
- DE-A1- 19 840 944
- DE-A1-102010 047 128
- DE-A1-102011 002 741
- US-A- 6 019 086

## Beschreibung

Die Erfindung betrifft eine Radsensorvorrichtung für ein Fahrzeug. Des Weiteren betrifft die Erfindung ein Verfahren zum Montieren einer Radsensorvorrichtung.

### Stand der Technik

In der DE 11 2010 003 926 T5 ist eine Radlagervorrichtung mit einer integrierten Drehzahldetektionsvorrichtung beschrieben. Die integrierte Drehzahldetektionsvorrichtung weist eine Sensoreinheit mit einem Drehzahlsensor auf, welche in eine Sensoraufnahme der Radlagervorrichtung integriert ist.

In der US 6,019,086 A und in der DE 10 2010 047 128 A1 sind Drehzahldetektionsvorrichtungen beschrieben, welche mit je zwei Drehzahlsensoren ausgestattet sind. Außerdem beschreibt die DE 10 2011 002 741 A1 ein Sensormodul mit einem Gehäuse, welches mit einem ersten Aufnahmebereich zu Aufnahme eines ersten Sensorträgers und einem zweiten Aufnahmebereich zu Aufnahme eines zweiten Sensorträgers ausgebildet ist.

Die DE 198 40 944 A1 beschreibt ein Sensorsystem mit mehreren Sensoren, die bei einer Betätigung eines Bremspedals ein einer aktuellen Position des Bremspedals entsprechendes Signal erzeugen, wobei die Sensoren an zwei unterschiedliche Energiequellen angebunden sind. Eine Sensorik mit mehreren Sensoren und einer redundanten Spannungsversorgung ist auch in der DE 100 41 989 A1 offenbart.

### Offenbarung der Erfindung

Die Erfindung schafft eine Radsensorvorrichtung für ein Fahrzeug mit den Merkmalen des Anspruchs 1 und ein Verfahren zum Montieren einer Radsensorvorrichtung mit den Merkmalen des Anspruchs 3.

### Vorteile der Erfindung

Die vorliegende Erfindung schafft einfach realisierbare Möglichkeiten zum Ermitteln von Informationen bezüglich eines Drehverhaltens eines (einzigen) Rads, wie z.B. einer Drehzahl und/oder einer Drehgeschwindigkeit des Rads, mittels zweier Drehzahlsensoren. Beispielsweise erleichtert die Radsensorvorrichtung ein gemeinsames Anordnen des ersten Drehzahlsensors und des zweiten Drehzahlsensors benachbart zu dem zugeordneten (gleichen) Rad. Das Montieren der beiden Drehzahlsensoren an (gleichen) Rad erfordert in diesem Fall gegenüber einer herkömmlichen Montage von nur einem Drehzahlsensor pro Rad keinen/kaum einen zusätzlichen Arbeitsaufwand.

Durch die Verwendung der zwei Drehzahlsensoren beim Ermitteln der Informationen bezüglich des Drehverhaltens des Rads (wie z.B. der Drehzahl und/oder Drehgeschwindigkeit des jeweiligen Rads) sind die Zahlenwerte mit einer größeren Genauigkeit und mit einer geringeren Fehlerhäufigkeit festlegbar. Außerdem ist ein Ausfall/eine Funktionsbeeinträchtigung des ersten Drehzahlsensors verlässlich mittels des noch einsetzbaren zweiten Drehzahlsensors kompensierbar. Entsprechend kann auch ein zumindest zeitweiser Ausfall des zweiten Drehzahlsensors mittels des ersten Drehzahlsensors überbrückt werden.

Aufgrund der mittels der vorliegenden Erfindung gewährleisteten genaueren Festlegung der Drehzahl und/oder der Drehgeschwindigkeit des jeweiligen Rads bei gleichzeitig sichergestellter geringer Fehlerrate ist eine von einem Fahrer oder einer Geschwindigkeitsautomatik angeforderte Verzögerung in der Regel unter Beibehaltung einer gewünschten Stabilität des jeweiligen Fahrzeugs besser realisierbar. Aufgrund der mittels der vorliegenden Erfindung trotz eines Ausfalls eines der Drehzahlsensoren weiterhin sichergestellten Verfügbarkeit von aktuellen Werten bezüglich des Drehverhaltens des Rads ermöglicht die Aufrechterhaltung einer Bremsregelung, und damit auch die Aufrechterhaltung eines Bremskomforts selbst in einer derartigen Situation.

Außerdem ist selbst bei einem Ausfall einer der beiden Spannungsquellen (Stromquellen) noch mindestens einer der zwei Drehzahlsensoren funktionsfähig.

Bevorzugterweise ist die Steckerkomponente direkt oder indirekt so an einer ersten Steuerelektronik des Fahrzeugs anbindbar, dass mindestens ein erstes Sensorsignal bezüglich der Änderung der mindestens einen ersten physikalischen Größe in dem ersten Drehzahlsensor und/oder einer davon abgeleiteten ersten Information bezüglich eines Drehverhaltens des Rads an die erste Steuerelektronik ausgebbar ist. In einer vorteilhaften Ausbildung der Radsensorvorrichtung ist die Steckerkomponente direkt oder indirekt auch an einer zweiten Steuerelektronik des Fahrzeugs so anbindbar, dass mindestens ein zweites Sensorsignal bezüglich der Änderung der mindestens einen zweiten physikalischen Größe in dem zweiten Drehzahlsensor und/oder einer davon abgeleiteten zweiten Information bezüglich des Drehverhaltens des Rads an die zweite Steuerelektronik ausgebbar ist. Dies verbessert eine Verfügbarkeit von mindestens einem der Sensorsignale an mindestens einer der Steuerelektroniken, wodurch sicherstellbar ist, dass (nahezu) immer mindestens eine der Steuerelektroniken mindestens eine von ihr ansteuerbare Fahrzeugkomponente unter Berücksichtigung eines Drehverhaltens des der Radsensorvorrichtung zugeordneten Rads ansteuern kann.

In einer weiteren vorteilhaften Ausführungsform der Radsensorvorrichtung ist das Sensorgehäuse mit dem eingesetzten ersten Drehzahlsensor und dem eingesetzten zweiten Drehzahlsensor benachbart zu dem Rad und dem Drehgeber in einer Radlagervorrichtung an dem Fahrzeug montierbar. (Unter dem Begriff "Radlagervorrichtung" kann z.B. ein Radlager verstanden werden, ohne dass die Radlagervorrichtung auf einen bestimmten Radlagertyp beschränkt ist.) Dies erlaubt ein fortlaufendes Neufestlegen von aktuellen Werten bezüglich des Drehverhaltens des jeweiligen Rads mit einer hohen Genauigkeit und einer geringen Fehlerrate.

Des Weiteren stellt auch das korrespondierende Verfahren zum Montieren einer entsprechenden Radsensorvorrichtung die oben beschriebenen Vorteile sicher.

Auch das Verfahren zum Montieren der Radsensorvorrichtung ist gemäß den oben beschriebenen Ausführungsformen der Radsensorvorrichtung weiterbildbar.

### Kurze Beschreibung der Zeichnungen

Weitere Merkmale und Vorteile der vorliegenden Erfindung werden nachfolgend anhand der Figuren erläutert. Es zeigen:
- Fig. 1a bis 1c: schematische Gesamt- und Teildarstellungen einer ersten Ausführungsform der Radsensorvorrichtung;
- Fig. 2 bis 12: schematische Gesamt- oder Teildarstellungen von Beispielen, welche nicht unter den beanspruchten Gegenstand fallen sowie von weiteren Ausführungsformen der Radsensorvorrichtung; hierbei beziehen sich die Beispiele der Figuren 3,4,5 und 7 nicht auf die beanspruchte Erfindung
- Fig. 13: eine schematische Darstellung einer Anbindungskomponente, welche nicht unter die vorliegende Erfindung fällt;
- Fig. 14: ein Flussdiagramm zum Erläutern eines Herstellungsverfahrens, welches nicht unter die vorliegende Erfindung fällt; und
- Fig. 15: ein Flussdiagramm zum Erläutern einer Ausführungsform des Verfahrens zum Montieren einer Radsensorvorrichtung.

### Ausführungsformen der Erfindung

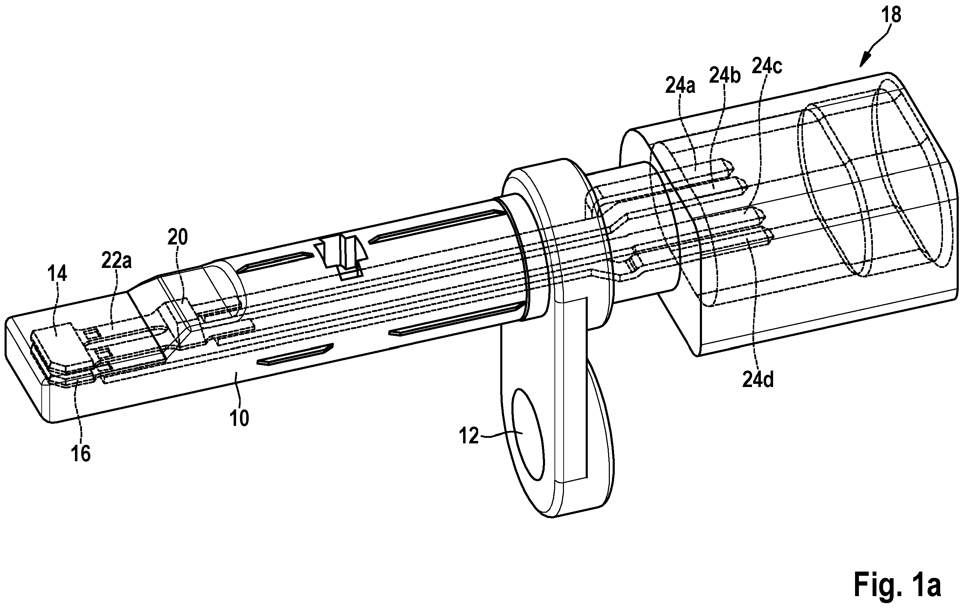

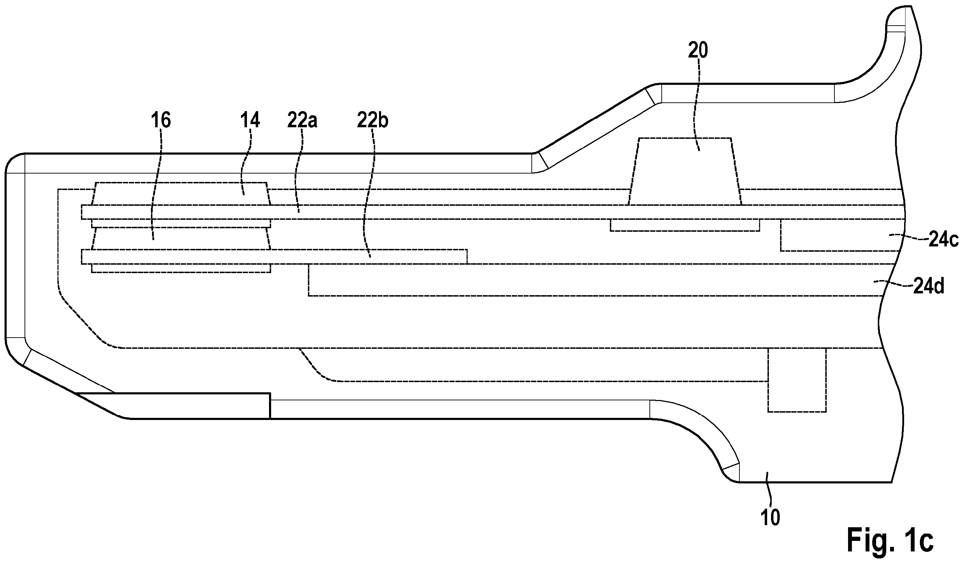

Fig. 1a bis 1c zeigen schematische Gesamt- und Teildarstellungen einer ersten Ausführungsform der Radsensorvorrichtung.

Die in Fig. 1a bis 1c schematisch dargestellte Radsensorvorrichtung hat ein Sensorgehäuse 10, welches derart an einem Fahrzeug/Kraftfahrzeug montierbar ist, dass die Radsensorvorrichtung auf die nachfolgend beschriebene Weise mit einem (direkt oder indirekt) an einem Rad des Fahrzeugs angebrachten Drehgeber zusammenwirken kann. Es wird darauf hingewiesen, dass eine Verwendbarkeit des Sensorgehäuses 10 nicht auf einen bestimmten Fahrzeugtyp/Kraftfahrzeugtyp des Fahrzeugs/Kraftfahrzeugs limitiert ist. Auch die in Fig. 1a bis 1c wiedergegebene Form des Sensorgehäuses 10, insbesondere seine Ausbildung mit einem Befestigungsring 12, ist lediglich beispielhaft zu verstehen.

In dem Sensorgehäuse 10 ist ein erster Drehzahlsensor 14 (Raddrehzahlsensor) angeordnet. Der erste Drehzahlsensor 14 kann beispielsweise in einer (nicht skizzierten) ersten Aufnahmeöffnung des Sensorgehäuses 10 eingesetzt sein. Unter dem ersten Drehzahlsensor 14 ist ein erstes sensitives Element zu verstehen, welches derart ausgelegt ist, dass nach einer Montage des Sensorgehäuses 10 mit dem ersten Drehzahlsensor 14 darin an dem Fahrzeug der mit dem rotierenden Rad des Fahrzeugs mitrotierende Drehgeber eine Änderung mindestens einer ersten physikalischen Größe in dem ersten Drehzahlsensor 14 auslöst. Durch ein Auswerten der Änderung der mindestens einen ersten physikalischen Größe in dem ersten Drehzahlsensor 14 ist mindestens eine erste Information bezüglich eines Drehverhaltens des mit dem Drehgeber ausgestatteten Rads (bzw. einer jeweiligen Achse), wie z.B. ein erster Wert einer Drehzahl des Rads (bzw. des an dem Rad angebrachten Drehgebers), bestimmbar. Beispielsweise kann mindestens eine (nicht skizzierte) Auswerteeinrichtung der Radsensorvorrichtung dazu ausgelegt sein, unter Berücksichtigung der Änderung der mindestens einen ersten physikalischen Größe in dem ersten Drehzahlsensor 14 die mindestens eine erste Information bezüglich des Drehverhaltens des mit dem Drehgeber ausgestatteten Rads, insbesondere den ersten Wert der Drehzahl, festzulegen und auszugeben. Ebenso kann jedoch auch ein erstes Sensorsignal bezüglich der Änderung der mindestens einen ersten physikalischen Größe in dem ersten Drehratensensor 14 an eine externe Auswerteelektronik ausgebbar sein, welche anschließend die mindestens eine erste Information bezüglich des Drehverhaltens des mit dem Drehgeber ausgestatteten Rads festlegt. Der erste Drehzahlsensor 14 kann insbesondere ein (erster) Drehzahlfühler sein.

Zusätzlich zu dem ersten Drehzahlsensor 14 ist ein zweiter Drehzahlsensor 16 (Raddrehzahlsensor) in dem Sensorgehäuse 10 angeordnet. Der zweite Drehzahlsensor 16 kann beispielsweise in der ersten Aufnahmeöffnung oder einer zweiten Aufnahmeöffnung des Sensorgehäuses 10 eingesetzt sein. Unter dem zweiten Drehzahlsensor 16 ist ein zweites sensitives Element zu verstehen, welches derart ausgebildet ist, dass nach der Montage des Sensorgehäuses 10 mit dem ersten Drehzahlsensor 14 und dem zweiten Drehzahlsensor 16 darin an dem Fahrzeug der mit dem rotierenden Rad mitrotierende Drehgeber die Änderung der mindestens einen ersten physikalischen Größe in dem ersten Drehzahlsensor 14 und zusätzlich eine Änderung mindestens einer zweiten physikalischen Größe in dem zweiten Drehzahlsensor 16 auslöst. Deshalb ist durch ein Auswerten der Änderung der mindestens einen zweiten physikalischen Größe in dem zweiten Drehzahlsensor 16 noch mindestens eine zweite Information bezüglich des Drehverhaltens des mit dem Drehgeber ausgestatteten Rads, wie z.B. ein zweiter Wert der Drehzahl des Rads (bzw. des an dem Rad angebrachten Drehgebers), bestimmbar. Das Bestimmen/Festlegen der mindestens einen zweiten Information bezüglich des Drehverhaltens des mit dem Drehgeber ausgestatteten Rads kann mittels der mindestens einen (nicht skizzierten) Auswerteeinrichtung der Radsensorvorrichtung und/oder (nach einem Ausgeben eines zweiten Sensorsignals bezüglich der Änderung der mindestens einen zweiten physikalischen Größe in dem zweiten Drehzahlsensor 16) durch die externe Auswerteelektronik erfolgen. Auch der zweite Drehzahlsensor 16 kann ein (weiterer/zweiter) Drehzahlfühler sein.

Aufgrund der Ausstattung der Radsensorvorrichtung mit den beiden Drehzahlsensoren 14 und 16 für das (gleiche) mit dem Drehgeber ausgestattete Rad können die Informationen und/oder Werte bezüglich des Drehverhaltens des Rads verlässlicher bestimmt werden. Beispielsweise kann die Drehzahl des Rads über eine Mittelwertbildung genauer festgelegt werden. Ebenso kann, sofern lediglich einer der beiden Drehzahlsensoren 14 und 16 des (gleichen) Rads einen Extremwert ermittelt, verlässlich auf einen an dem jeweiligen Drehratensensor 14 oder 16 vorliegenden Fehler rückgeschlossen werden. Die Ausstattung der Radsensorvorrichtung mit den beiden Drehzahlsensoren 14 und 16 ermöglicht somit ein Untersuchen des Drehverhaltens des Rads mit einer größeren Genauigkeit und einer geringeren Fehlerrate. Durch die gemeinsame Verwendbarkeit der beiden Drehratensensoren 14 und 16 für das (gleiche) Rad ist auch automatisch eine Qualitätsüberprüfung der ermittelten Informationen und/oder Werte möglich. Gegebenenfalls kann auch das Vorliegen eines Fehlers an einem der beiden Drehzahlsensoren 14 und 16 oder ein Ausfall eines der beiden Drehzahlsensoren 14 und 16 mittels des anderen der beiden Drehzahlsensoren 14 und 16 überbrückt werden. Die Radsensorvorrichtung stellt somit sicher, dass in einer derartigen Situation noch eine verlässliche Untersuchung/Ermittlung des Drehverhaltens des mit dem Drehgeber ausgestatteten Rads möglich ist.

Vorzugsweise erfolgt die mittels des rotierenden Drehgebers ausgelöste Änderung der mindestens einen ersten physikalischen Größe in dem ersten Drehzahlsensor 14 unabhängig/unbeeinflusst von der (zusätzlichen) Änderung der mindestens einen zweiten physikalischen Größe in dem zweiten Drehzahlsensor 16. Entsprechend wird es auch bevorzugt, wenn die mittels des rotierenden Drehgebers ausgelöste Änderung der mindestens einen zweiten physikalischen Größe in dem zweiten Drehzahlsensor 16 unabhängig/unbeeinträchtigt von der (zusätzlichen) Änderung der mindestens einen ersten physikalischen Größe in dem ersten Drehzahlsensor erfolgt. Die Ausstattung der Radsensorvorrichtung mit den beiden Drehzahlsensoren 14 und 16 (für das gleiche mit dem Drehgeber ausgestattete Rad) schafft somit eine vorteilhafte Redundanz.

Unter dem Drehgeber kann ein Signalgeber/Drehsignalgeber verstanden werden. Der Drehgeber kann insbesondere ein magnetischer Drehgeber sein. Der Drehgeber kann beispielsweise ein Encoder und/oder Inkrementalgeber/ Inkrementalrad sein. Beispielsweise können die Drehzahlsensoren 14 und 16 so ausgelegt sein, dass über einen Hall-Effekt aufgrund des rotierenden Drehgebers ein erster Widerstand und/oder eine erste Spannung als die mindestens eine erste physikalische Größe in dem ersten Drehzahlsensor 14 und ein zweiter Widerstand und/oder eine zweite Spannung als die mindestens eine zweite physikalische Größe in dem zweiten Drehzahlsensor 16 verändert/variiert werden. Es wird jedoch darauf hingewiesen, dass eine Ausbildbarkeit des ersten Drehzahlsensors 14 und/oder des zweiten Drehzahlsensors 16 nicht auf eine Ausnutzung des Hall-Effekts limitiert ist. Beispielsweise können auch ein Anisotroper magnetischer Effekt (AMR), ein Riesenmagnetowiderstand (GMR) und/oder ein magnetischer Tunnelwiderstand (TMR) anstelle oder als Ergänzung zu dem Hall-Effekt für die Drehzahlsensoren genutzt werden.

Vorzugsweise sind die beiden Drehzahlsensoren 14 und 16 nah aneinander angeordnet, ohne dass sich beide Drehzahlsensoren 14 und 16 gegenseitig beeinflussen. Beispielsweise kann der zweite Drehratensensor 16 "huckepack" an dem ersten Drehratensensor 14 positioniert sein. Bei einer Anordnung der beiden Drehzahlsensoren 14 und 16 nah aneinander kann der zweite Drehzahlsensor 16 einen (minimalen) Abstand zu dem vorbei laufenden Drehgeber aufweisen, welcher größer als ein (minimaler) Abstand des ersten Drehzahlsensors 14 zu dem vorbei laufenden Drehgeber ist. Häufig ist eine Funktion eines Drehzahlsensors 14 oder 16 jedoch abhängig von einem (minimalen) Abstand zwischen dem Drehzahlsensor 14 oder 16 und dem daran vorbei laufenden Drehgeber. Vorteilhafter Weise können in diesem Fall der erste Drehzahlsensor 14 einen ersten Drehzahlsensortyp und der zweite Drehzahlsensor 16 einen von dem ersten Drehzahlsensortyp abweichenden zweiten Drehzahlsensortyp aufweisen, wobei der zweite Drehzahlsensortyp für einen kleineren (minimalen) Abstand ausgelegt/geeignet ist als der erste Drehzahlsensortyp. Der erste Drehzahlsensortyp oder der zweite Drehzahlsensortyp können z.B. ein AMR-Sensortyp (Anisotroper magnetischer Effekt), ein GMR-Sensortyp (Riesenmagnetowiderstand) ein TMR-Sensortyp (magnetischer Tunnelwiderstand) und/oder ein Hall-Sensortyp sein, wobei die beiden Drehzahlsensortypen voneinander abweichen können.

Der erste Drehzahlsensor 14 und der zweite Drehzahlsensor 16 können ein erster DF-ASIC 14 und ein zweiter DF-ASIC 16 sein. Beispielsweise kann der zweite DF-ASIC 16 als der zweite Drehzahlsensor 16 "huckepack" an dem ersten DF-ASIC 14 als dem ersten Drehzahlsensor 14 positioniert sein. Eine derartige Anordnung/Ausbildung der beiden Drehzahlsensoren 14 und 16 erlaubt eine vollständige redundante Signalermittlung und Signalauswertung für das (mit dem Drehgeber ausgestattete) Rad. Zur Vermeidung von Funktionseinbußen können für den ersten DF-ASIC 14 ein erster DF-ASIC-Typ und für den zweiten DF-ASIC 16 ein von dem ersten DF-ASIC-Typ abweichender zweiter DF-ASIC-Typ eingesetzt sein, wobei der zweite DF-ASIC-Typ für einen kleineren (minimalen) Abstand ausgelegt/geeignet ist als der erste DF-ASIC-Typ. Beispielweise kann der zweite DF-ASIC 16 ein DF-ASIC mit hoher Empfindlichkeit, insbesondere ein TLE5041plusC, sein.
Das Sensorgehäuse 10 mit dem eingesetzten ersten Drehratensensor 14 und dem eingesetzten zweiten Drehratensensor 16 kann benachbart zu dem (gleichen) Rad und seinem zugeordneten Drehgeber in einer (gemeinsamen) Radlagervorrichtung/einem (gemeinsamen) Radlager an dem Fahrzeug montierbar sein (hier nicht dargestellt). Es wird darauf hingewiesen, dass diese Anordbarkeit des Sensorgehäuses 10 nicht auf einen bestimmten Radlagertyp beschränkt ist. Stattdessen ist die Radlagervorrichtung/das Radlager zum Anordnen der Radsensorvorrichtung mit einer großen Designfreiheit ausbildbar.

Als vorteilhafte Weiterbildung hat das Sensorgehäuse 10 der Radsensorvorrichtung der Fig. 1a bis 1c eine Steckerkomponente 18, wobei der erste Drehzahlsensor 14 und der zweite Drehzahlsensor 16 jeweils (direkt oder über mindestens eine Auswerteeinrichtung) an der Steckerkomponente 18 angebunden sind. Unter der Steckerkomponente 18 kann beispielsweise ein Anschlussteil verstanden werden, an welcher mindestens ein Gerät und/oder mindestens ein Kabel ansteckbar ist. Vorzugsweise sind das jeweilige Gerät und/oder das jeweilige Kabel so an der Steckerkomponente 18 ansteckbar, dass eine Strom-, Spannungs- und/oder Signalübertragung zwischen der Radsensorvorrichtung und dem mindestens einen an der Steckerkomponente 18 angesteckten Gerät und/oder mindestens einem weiteren Gerät, welches an das mindestens eine an der Steckerkomponente 18 angesteckte Kabel angebunden ist, gewährleistet ist. Die Steckerkomponente 18 kann beispielsweise ein Steckergehäuse/eine Steckerbuchse oder ein Stecker/Steckerteil sein. Anstelle einer an dem Sensorgehäuse 10 (direkt) ausgebildeten Steckerkomponente 18 kann die Steckerkomponente 18 auch über ein Kabel an dem Sensorgehäuse 10 angebunden sein.

Vorzugsweise ist die Steckerkomponente 18 eine vierpolige oder 2 x 2-polige Steckerkomponente 18. (Darunter fallen auch 2 Kabelabgänge mit je einem 2-poligen Stecker oder ein Kabelabgang mit einem 4-poligen Stecker.) Auf die Vorteile dieser Ausbildungsmöglichkeiten der Steckerkomponente 18 wird unten noch genauer eingegangen.

Die Steckerkomponente 18 ist direkt oder indirekt so an einer ersten Spannungsquelle (ersten Stromquelle) des Fahrzeugs anbindbar, dass eine erste Spannung (ein erster Versorgungsstrom) zumindest an den ersten Drehzahlsensor 14 bereitstellbar ist. Zusätzlich ist die Steckerkomponente 18 direkt oder indirekt so an einer zweiten Spannungsquelle (zweiten Stromquelle) des Fahrzeugs anbindbar, dass eine zweite Spannung (ein zweiter Versorgungsstrom) zumindest an den zweiten Drehzahlsensor 16 bereitstellbar ist. Auf diese Weise ist selbst bei einem (vollständigen) Funktionsausfall einer der beiden Spannungsquellen (Stromquellen) noch ein verlässlicher Betrieb mindestens eines der beiden dem (gleichen) Rad zugeordneten Drehzahlsensoren 14 und 16 sichergestellt. Zwar kann der (vollständige) Funktionsausfall einer der beiden Spannungsquellen (Stromquellen) zu einem Funktionsausfall eines der beiden Drehzahlsensoren 14 und 16 führen, der andere der Drehzahlsensoren 14 und 16 bleibt jedoch (aufgrund seiner weiterhin sichergestellten Spannungsversorgung/Bestromung) voll funktionsfähig. Das Drehverhalten des den Drehzahlsensoren 14 und 16 zugeordneten Rads ist deshalb trotz des (vollständigen) Funktionsausfalls einer der beiden Spannungsquellen (Stromquellen) weiterhin noch untersuchbar/ermittelbar. Die erste Spannungsquelle (erste Stromquelle) und die zweite Spannungsquelle (zweite Stromquelle) können beispielsweise eine Fahrzeugbatterie und/oder ein Hochspannungsnetz sein.

Insbesondere kann die erste Spannungsquelle (Stromquelle) zur Spannungsversorgung/Bestromung eines elektromechanischen Bremskraftverstärkers des mit der Radsensorvorrichtung ausgestatteten Fahrzeugs verwendet werden, während die zweite Spannungsquelle (Stromquelle) zur Spannungsversorgung/Bestromung mindestens einer strombetriebenen Hydraulikkomponente des Bremssystems des Fahrzeugs, wie z.B. mindestens eines elektrisch ansteuerbaren Ventils, mindestens eines Pumpenmotors und/oder mindestens einer motorisierten Kolben-ZylinderVorrichtung, vorzugsweise des gesamten Hydrauliksystems/ESP-Systems des Bremssystems, genutzt wird. In diesem Fall ist trotz eines (vollständigen) Funktionsausfalls einer der beiden Spannungsquellen (Stromquellen) noch immer ein zum Ausführen/Unterstützen einer Bremsung ausreichender Teil des Bremssystems des mit der Radsensorvorrichtung ausgestatteten Fahrzeugs zusammen mit einem der beiden Drehzahlsensoren 14 und 16 voll funktionsfähig.

Außerdem ist es vorteilhaft, dass die Steckerkomponente 18 direkt oder indirekt so an einer ersten Steuerelektronik des Fahrzeugs anbindbar ist, dass das mindestens eine erste Sensorsignal bezüglich der Änderung der mindestens einen ersten physikalischen Größe in dem ersten Drehzahlsensor 14 und/oder der davon abgeleiteten ersten Information bezüglich des Drehverhaltens des (mit dem Drehgeber ausgestatteten) Rads an die erste Steuerelektronik ausgebbar ist, während die Steckerkomponente (gleichzeitig) direkt oder indirekt so an einer zweiten Steuerelektronik des Fahrzeugs anbindbar ist, dass das mindestens eine zweite Sensorsignal bezüglich der Änderung der mindestens einen zweiten physikalischen Größe in dem zweiten Drehzahlsensor 16 und/oder der davon abgeleiteten zweiten Information bezüglich des Drehverhaltens des (mit dem Drehgeber ausgestatteten) Rads an die zweite Steuerelektronik ausgebbar ist. Die Redundanz der beiden Drehzahlsensoren 14 und 16 für das (gleiche) Rad ist somit auch bezüglich eines (vollständigen) Ausfallens einer der beiden Steuerelektroniken des Fahrzeugs absicherbar. Auf diese Weise ist sicherstellbar, dass selbst bei einem (vollständigen) Ausfall einer der beiden Steuerelektroniken mindestens eines der beiden Sensorsignale und/oder eine der Informationen bezüglich des Drehverhaltens des Rads noch mittels der weiterhin funktionsfähigen Steuerelektronik zum Ansteuern mindestens einer Fahrzeugkomponente nutzbar sind.

In einer vorteilhaften Ausführungsform kann die erste Steuerelektronik zum Ansteuern/Betreiben des elektromechanischen Bremskraftverstärkers ausgelegt sein, während die mindestens eine strombetriebene Hydraulikkomponente mittels der zweiten Steuerelektronik ansteuerbar/betreibbar ist. Eine entfallende Einsetzbarkeit des elektromechanischen Bremskraftverstärkers oder der mindestens einen strombetriebenen Hydraulikkomponente (z.B. aufgrund eines Ausfalls einer der beiden Spannungsquellen) kann in diesem Fall unter Berücksichtigung mindestens eines der beiden Sensorsignale und/oder einer der Informationen bezüglich des Drehverhaltens des Rads
schnell mittels eines angepassten Ansteuerns der noch funktionsfähig vorliegenden Fahrzeugkomponente kompensiert werden.

In der Ausführungsform der Fig. 1a bis 1c ist dem ersten Drehzahlsensor 14 noch ein Kondensator 20 zugeordnet. Auf eine Ausstattung des zweiten Drehzahlsensors 16 mit einem (eigenen) Kondensator kann verzichtet werden. Der Verzicht einer Ausstattung des zweiten Drehratensensors 16 mit einem (eigenen) Kondensator ermöglicht eine Minimierung der Radsensorvorrichtung. Insbesondere kann in diesem Fall eine einzige Montagebohrung für beide Drehzahlsensoren 14 und 16 und dem (einzigen) Kondensator 20 ausreichen.

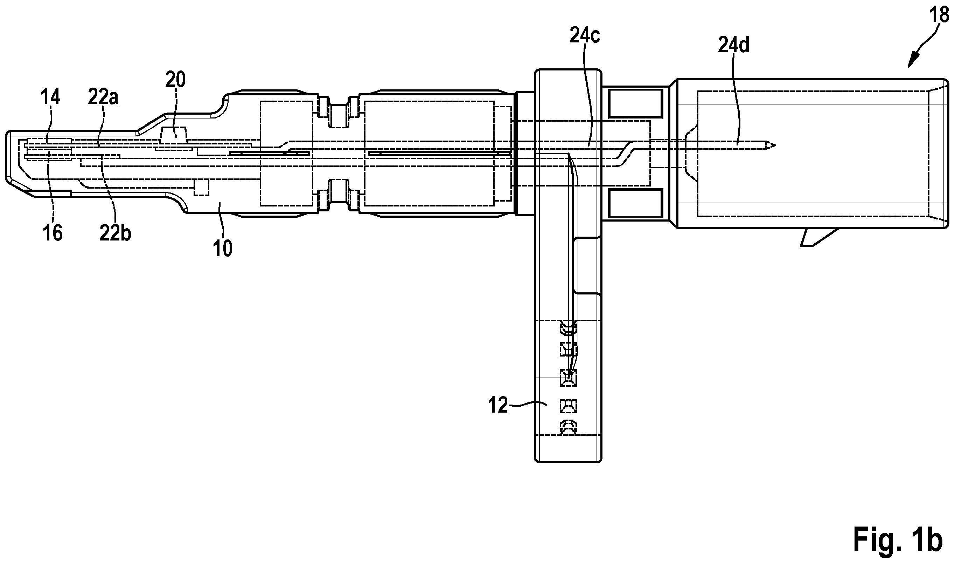

Lediglich beispielhaft ist in der Ausführungsform der Fig. 1a bis 1c jeder der Drehzahlsensoren 14 und 16 auf einem eigenen Chip 22a und 22b (Siliziumchip) ausgebildet. Alternativ können die beiden Drehzahlsensoren 14 und 16 auch auf einem gemeinsamen Chip ausgebildet sein. Ebenso ist die in Fig. 1a und 1b schematisch dargestellte Anzahl von vier Stromschienen 24a bis 24d, wobei sich die Stromschienen 24a und 24b von dem ersten Drehratensensor 14 (bzw. dessen ersten Chip 22a) bis zu der Steckerkomponente 18 erstrecken und sich die Stromschienen 24c und 24d von dem zweiten Drehratensensor 16 (bzw. dessen zweiten Chip 22b) zu der Steckerkomponente 18 erstrecken, nur beispielhaft zu interpretieren. Wie unten genauer erläutert wird, ist eine Ausstattung jedes der Drehratensensoren 14 und 16 mit zwei ihm zugeordneten Stromschienen 24a bis 24d nicht notwendig.

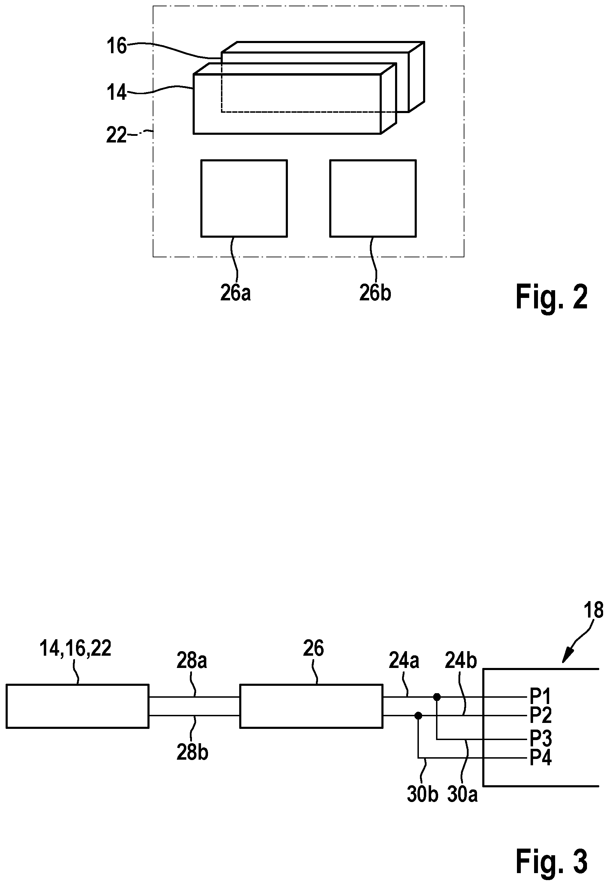

Fig. 2 bis 12 zeigen schematische Gesamt- oder Teildarstellungen von nicht beanspruchten, als Hintergrundinformation dienenden Ausführungsformen sowie von weiteren Ausführungsformen der Radsensorvorrichtung.

Die in den Fig. 2 bis 12 (zumindest teilweise) schematisch dargestellten Radsensorvorrichtungen können, sofern nachfolgend nichts Gegenteiliges beschrieben ist, zumindest einige der Eigenschaften der vorausgehenden Ausführungsform aufweisen.

Bei der in Fig. 2 nur teilweise dargestellten Radsensorvorrichtung sind die beiden Drehzahlsensoren 14 und 16 (in unterschiedlichen Ebenen) an dem gleichen Chip 22 (Siliziumchip) befestigt. Mittels einer derartigen Anordnung der beiden Drehzahlsensoren 14 und 16 ist ein Auslösen der gewünschten Änderung der jeweiligen mindestens einen physikalischen Größe in den Drehzahlsensoren 14 und 16 mittels des sich daran vorbei bewegenden Drehgebers verlässlich sichergestellt. Die Änderung der jeweiligen mindestens einen physikalischen Größe ist deshalb verlässlich mittels mindestens einer Auswerteeinrichtung 26a und 26b feststellbar, wobei mittels der mindestens einen Auswerteeinrichtung 26a und 26b eine der Änderung entsprechende erste/zweite Information bezüglich des Drehverhaltens des mit dem Drehgeber ausgestatteten Rads, wie z.B. ein erster/zweiter Wert der Drehzahl des Rads, festlegbar und ausgebbar sind. In der Ausführungsform der Fig. 2 ist jedem Drehzahlsensor 14 und 16 eine eigene Auswerteeinrichtung 26a oder 26b zugeordnet. Die beiden Auswerteeinrichtungen 26a und 26b sind elektrisch vollständig voneinander getrennt.

In der nicht erfindungsgemäßen Ausführungsform der Fig. 3 ist dem Chip 22 mit den Drehzahlsensoren 14 und 16 eine gemeinsame Auswerteeinrichtung 26 zugeordnet. Der Chip 22 ist dazu über zwei Stromschienen 28a und 28b mit der Auswerteeinrichtung 26 verbunden. Von der Auswerteeinrichtung 26 verlaufen zwei weitere Stromschienen 24a und 24b zu der 4-poligen Steckerkomponente 18. Von jeder der zwei Stromschienen 24a und 24b verzweigt sich je eine weitere Stromschiene 30a und 30b zu der Steckerkomponente 18, so dass jede der zwei Stromschienen 24a und 24b und jede der zwei weiteren Stromschienen 30a und 30b als insgesamt vier Pins P1 bis P4 in die Steckerkomponente 18 ragen. Man kann dies auch damit umschreiben, dass die Stromschnittstelle zwischen der Auswerteeinrichtung 26 und der Steckerkomponente 18 durch eine Verdoppelung der Stromschienen 24 und 24b für die 4-polige Steckerkomponente 18 ausgelegt ist. Aufgrund der Ausleitung ab dem Chip 22/der Auswerteeinrichtung 26 über nur zwei Stromschienen 24a, 24b, 28a und 28b und der entsprechenden Aufteilung in der Nähe der Steckerkomponente 18 sind Herstellungskosten der Radsensorvorrichtung der Fig. 3 reduziert. Gleichzeitig erleichtert die 4-polige Steckerkomponente 18 eine Signalweiterleitung von den beiden Drehratensensoren 14 und 16 an zwei verschiedene Steuerelektroniken (Steuergeräte).

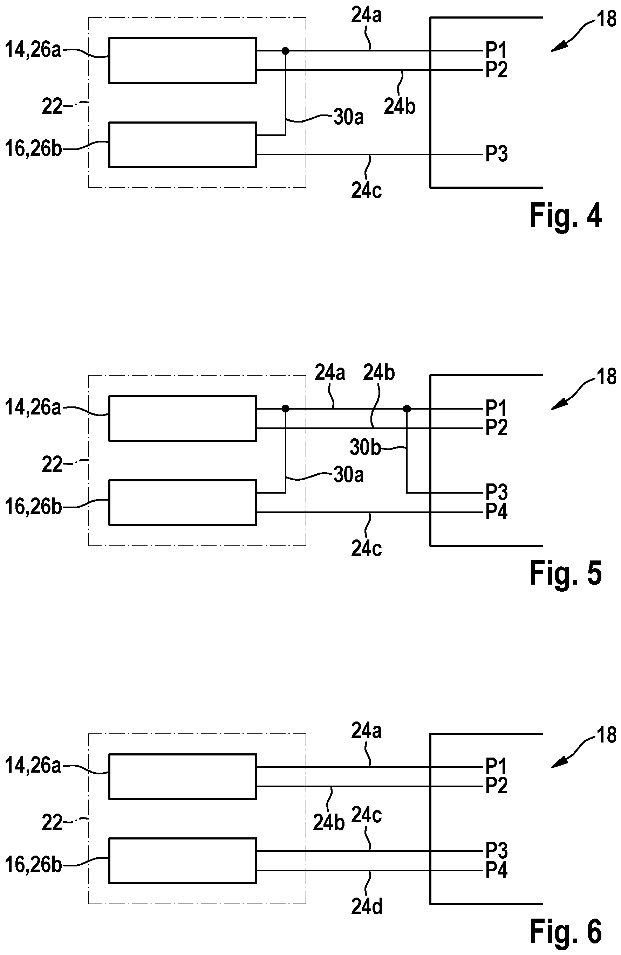

Auch bei der nicht erfindungsgemäßen Radsensorvorrichtung der Fig. 4 sind die beiden Drehzahlsensoren 14 und 16 auf dem gleichen Chip 22 angeordnet. Allerdings ist bei der Ausführungsform der Fig. 4 jede der Auswerteeinrichtungen 26a und 26b in den ihr zugeordneten Drehzahlsensor 14 oder 16 integriert. Von dem ersten Drehzahlsensor 14 (mit der darin integrierten ersten Auswerteeinrichtung 26a) erstrecken sich zwei Stromschienen 24a und 24b zu der 3-poligen Steckerkomponente 18. Von dem zweiten Drehratensensor 16 (mit der darin integrierten zweiten Sensoreinrichtung 26b) verläuft nur eine Stromschiene 24c zu der 3-poligen Steckerkomponente 18. Über eine weitere Stromschiene 30a ist der zweite Drehratensensor 16 (mit der darin integrierten zweiten Auswerteeinrichtung 26b) an eine der beiden Stromschienen 24a oder 24b des ersten Drehratensensors 14 (mit der darin integrierten ersten Auswerteeinrichtung 26a) angebunden. Selbst in diesem Fall ist noch eine redundante Spannungsversorgung (Stromversorgung) der beiden Drehzahlsensoren 14 und 16 (mit den darin integrierten Auswerteeinrichtungen 26a und 26b) mittels unterschiedlicher Spannungsquellen (Stromquellen) möglich. Durch die Ausbildung der Steckerkomponente 18 der Fig. 4 als 3-polige Steckerkomponente 18 (mit den drei Pins P1 bis P3) kann eine Stromschiene eingespart werden. Insbesondere kann die jeweilige Versorgungsleitung nur einmal an die Steckerkomponente 18 geführt werden.

Auch die nicht erfindungsgemäße Radsensorvorrichtung der Fig. 5 weist eine als gemeinsame Versorgungsleitung fungierende Stromschiene 24a oder 24b auf. Allerdings ist die Steckerkomponente 18 der Fig. 5 als 4-polige Steckerkomponente 18 (mit vier Pins P1 bis P4) ausgebildet. Dazu ist an der Steckerkomponente 18 eine weitere kontaktierbare Stromschiene 30b ausgebildet, welche an die jeweilige Versorgungsleitung 24a oder 24b angebunden ist. Durch die Ausbildung der Steckerkomponente 18 als 4-polige Steckerkomponente 18 ist eine zusätzliche Absicherung der Radsensorvorrichtung gegenüber einem Ausfall von Komponenten ihrer Spannungs- und Strombereitstellung möglich.

In der Ausführungsform der Fig. 6 erstrecken sich je zwei Stromschienen 24a und 24b oder 24c und 24d von jedem der beiden Drehzahlsensoren 14 und 16 (mit der jeweils darin integrierten Auswerteeinrichtung 26a oder 26b). Die Radsensorvorrichtung der Fig. 6 zeichnet sich damit durch eine vollständige redundate Signalerzeugung und Signalführung bis hin zum Abgriff der Steckerkomponente 18 aus.

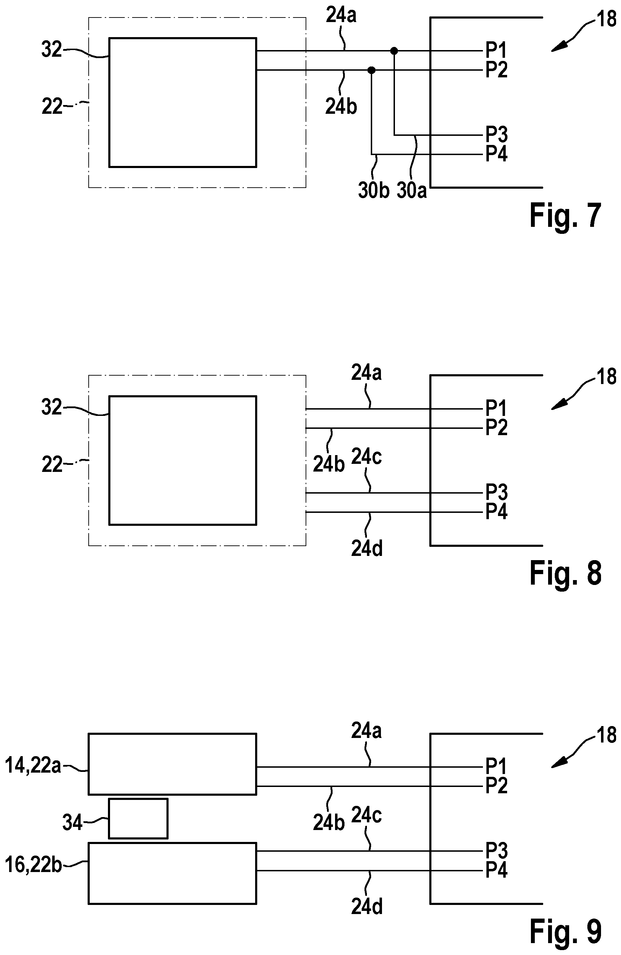

Bei der nicht erfindungsgemäßen Radsensorvorrichtung der Fig. 7 sind die beiden Drehzahlsensoren 14 und 16 (und die ihnen zugeordnete Auswerteeinrichtung 26) in eine gemeinsame Einheit 32 auf einem einzigen Chip 22 integriert. Zwei Stromschienen 24a und 24b erstrecken sich von der Einheit 32 zu der Steckerkomponente 18. Durch eine Verdoppelung der Schnittstellenströme für die Schnittstellen durch Verbindungsschienen lässt sich ein Stromfluss an der Schnittstelle idealerweise 50:50 aufteilen.

Im Gegensatz dazu verlaufen bei der Radsensorvorrichtung der Fig. 8 vier Stromschienen 24a bis 24d von dem Chip 22 zu der Steckerkomponente 18.

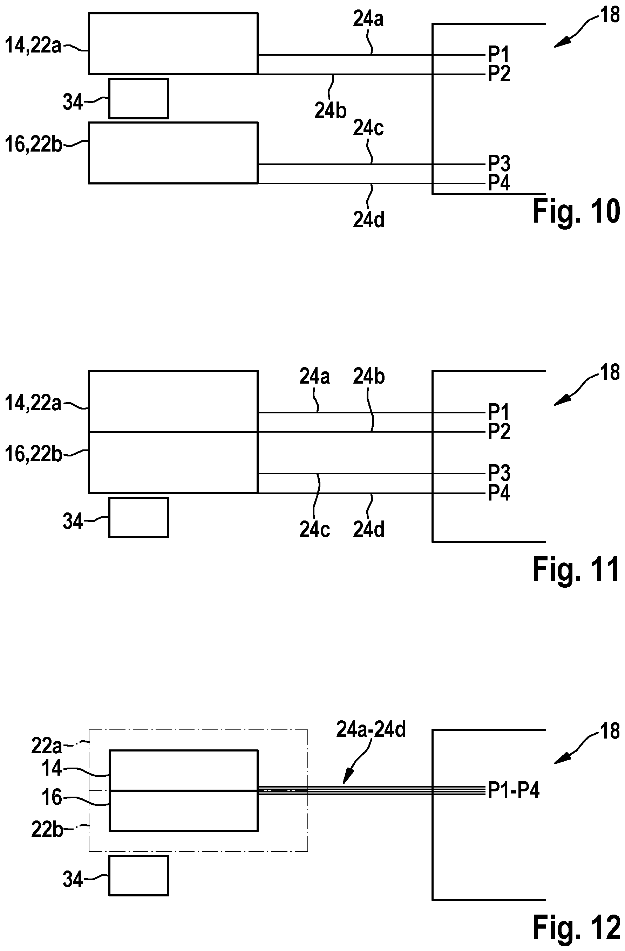

In den Ausführungsformen der Fig. 9 und 10 ist noch ein Magnet 34 zwischen dem ersten Chip 22a (mit dem ersten Drehzahlsensor 14) und dem zweiten Chip 22b (mit dem zweiten Drehzahlsensor 16) angeordnet. In der Ausführungsform der Fig. 9 ist die Steckerkomponente 18 als 4-polige Steckerkomponente 18 ausgebildet. Demgegenüber ist in der Ausführungsform der Fig. 10 die Steckerkomponente 18 als 2 x 2-polige Steckerkomponente 18 ausgelegt.

Wie in Fig. 11 erkennbar ist, kann der Magnet 34 auch auf einer von dem daran vorbei bewegten Drehgeber weg gerichteten Seite der beiden Drehratensensoren 14 und 16 angeordnet sein. Beispielhaft liegt in der Ausführungsform der Fig. 11 der zweite Chip 22b (mit dem zweiten Drehzahlsensor 16) zwischen den Magneten 34 und dem ersten Chip 22a (mit dem ersten Drehzahlsensor 14). Auch bei einer derartigen Anordnung des Magneten 34 ist eine gute Wechselwirkung der Drehratensensoren 14 und 16 mit dem Drehgeber sichergestellt.

In der Ausführungsform der Fig. 12 sind die beiden Chips 22a und 22b so zueinander gebracht, dass eine mit dem ersten Drehzahlsensor 14 bestückte erste Fläche des ersten Chips 22a zu einer mit dem zweiten Drehzahlsensor 16 bestückten zweiten Fläche des zweiten Chips 22b ausgerichtet ist und die beiden Drehzahlsensoren 14 und 16 "gestapelt" sind. Vorzugsweise liegt (nahezu) kein Luftspalt zwischen dem ersten Drehzahlsensor 14 und dem zweiten Drehzahlsensor 16 vor. Je zwei Stromschienen 24a und 24b oder 24c oder 24d verlaufen von jedem der Drehzahlsensoren 14 und 16 zu der Steckerkomponente 18. Auch in diesem Fall kann der Magnet 34 auf einer von dem daran vorbei bewegten Drehgeber weg gerichteten Seite der Chips 22a und 22b liegen.

In allen oben beschriebenen Ausführungsformen der Radsensorvorrichtung können die Drehzahlsensoren 14 und 16 (eventuell gemeinsam) gemoldet oder in einen Thermoplast eingebettet sein. Es wird noch einmal darauf hingewiesen, dass eine Ausstattung der Radsensorvorrichtung mit dem Magneten 34 lediglich optional ist. Anstelle des Magneten 34 kann auch ein Back Bias (BB) an der Radsensorvorrichtung angeordnet sein oder auf eine Ausstattung der Radsensorvorrichtung mit einem (eigenen) Magneten oder Back Bias (BB) ganz verzichtet werden.

Alle oben beschriebenen Radsensorvorrichtungen können als Drehzahlsensoren mit redundanten Drehzahlfühlern bezeichnet werden. Die Anzahl der Pins/Steckerpins ist von zwei auf vier gesteigert. Bei allen oben beschriebenen Radsensorvorrichtungen wird ein weiteres redundantes Sensorsignal (unter der Randbedingung einer geringstmöglichen gegenseitigen Funktionsbeeinflussung sowie größtmöglicher Robustheit bezüglich funktionaler Sicherheit) bereitgestellt. Außerdem lassen sich alle oben beschriebenen Radsensorvorrichtungen so ausbilden, dass die zusätzliche Ausbildung des zweiten Drehratensensors 16 darin ihre äußere Abmessung kaum beeinflusst. Sogar eine Aufnahme des jeweiligen Drehzahlsensors 14 und 16 kann (nahezu) unverändert bleiben. Alle oben beschriebenen Radsensorvorrichtungen lassen sich deshalb unter Nutzung einer Montagebohrung, welche am Rad des Fahrzeugs in der Regel bereits vorliegt, leicht montieren.

Ein mit einer oben beschriebenen Radsensorvorrichtung ausgestattetes Fahrzeug ist aufgrund der redundanten Drehzahl- und Drehgeschwindigkeitserfassung gut zum Ausführen einer Fahrzeugdynamikregelung, wie z.B. einer "Staupilot"-Funktion, ausgelegt. Auch ein Ausfall des ESP-Systems oder des elektromechanischen Bremskraftverstärkers kann bei einem derartigen Fahrzeug leichter und fahrerfreundlicher überbrückt werden.

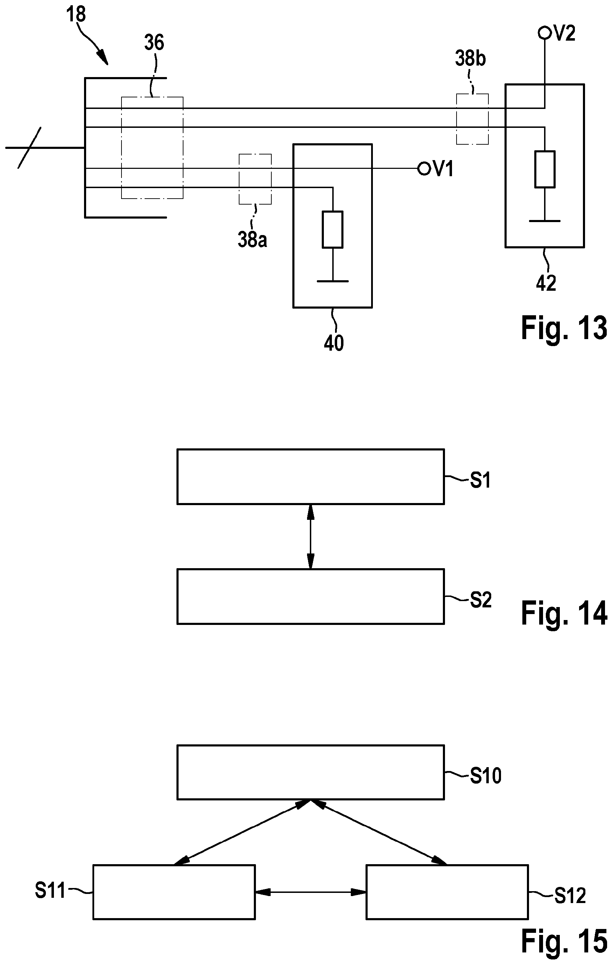

Fig. 13 zeigt eine schematische Darstellung einer Anbindungskomponente, welche nicht unter die vorliegende Erfindung fällt.

Die in Fig. 13 schematisch dargestellte Anbindungskomponente kann mit einer der oben beschriebenen Radsensorvorrichtungen zusammenwirken. Dazu umfasst die Anbindungskomponente ein Steckerkomponente-Kontaktteil 36, welches an der Steckerkomponente 18 der Radsensorvorrichtung ansteckbar ist. Außerdem hat die Anbindungskomponente ein erstes Anbindungs- oder Steckerteil 38a, welches an der ersten Spannungsquelle V1 und/oder der (nicht dargestellten) ersten Steuerelektronik anbindbar oder ansteckbar ist. Des Weiteren ist die Anbindungskomponente mit einem zweiten Anbindungs- oder Steckerteil 38b ausgestattet, welches an der zweiten Spannungsquelle V2 und/oder der (nicht skizzierten) zweiten Steuerelektronik anbindbar oder ansteckbar ist. Beispielhaft ist in der Ausführungsform der Fig. 13 das erste Anbindungs- oder Steckerteil 38a an einem von der ersten Spannungsquelle V1 versorgten ESP-System 40 angesteckt, während das zweite Anbindungs- oder Steckerteil 38b an einem von der zweiten Spannungsquelle V2 versorgten elektromechanischen Bremskraftverstärker 42 angesteckt ist. Dies ist jedoch nur beispielhaft zu interpretieren.

Es wird darauf hingewiesen, dass bei der in Fig. 13 gezeigten Anbindung der Widerstände der Komponenten 40 und 42 (bei gleichen Widerständen) eine Verdopplung der von der Radsensorvorrichtung ausgegebenen Stromsignale vorliegt. An den Komponenten 40 und 42 müssen deshalb keine Änderungen vorgenommen werden, um deren Zusammenwirken mit der Radsensorvorrichtung sicherzustellen.

Fig. 14 zeigt ein Flussdiagramm zum Erläutern eines Herstellungsverfahrens, welches nicht unter die vorliegende Erfindung fällt.

Alle oben beschriebenen Radsensorvorrichtungen sind mittels des im Weiteren beschriebenen Herstellungsverfahrens herstellbar. Es wird jedoch darauf hingewiesen, dass eine Ausführbarkeit des Herstellungsverfahrens nicht auf ein Produzieren dieser Radsensorvorrichtungen limitiert ist.

In einem Verfahrensschritt S1 wird ein erster Drehzahlsensor in einem Sensorgehäuse der Radsensorvorrichtung angeordnet. Zuvor, gleichzeitig oder danach wird in einem Verfahrensschritt S2 zusätzlich ein zweiter Drehzahlsensor benachbart zu dem ersten Drehzahlsensor in dem Sensorgehäuse angeordnet. Die Verfahrensschritte S1 und S2 werden derart ausgeführt, dass nach einem Montieren des Sensorgehäuses mit dem ersten Drehzahlsensor und dem zweiten Drehzahlsensor darin an dem Fahrzeug ein mit einem rotierenden Rad des Fahrzeugs mitrotierender Drehgeber eine Änderung mindestens einer ersten physikalischen Größe in dem ersten Drehzahlsensor und zusätzlich eine Änderung mindestens einer zweiten physikalischen Größe in dem zweiten Drehzahlsensor auslöst. Beispiele für den ersten Drehzahlsensor und den zweiten Drehzahlsensor sind oben schon genannt.

Fig. 15 zeigt ein Flussdiagramm zum Erläutern einer Ausführungsform des Verfahrens zum Montieren einer Radsensorvorrichtung.

Beim Ausführen des hier beschriebenen Verfahrens wird die Radsensorvorrichtung in einem Verfahrensschritt S10 derart an dem Fahrzeug angeordnet/montiert, dass der mit dem rotierenden Rad mitrotierende Drehgeber die Änderung der mindestens einen ersten physikalischen Größe in dem ersten Drehzahlsensor und zusätzlich die Änderung der mindestens einer zweiten physikalischen Größe in dem zweiten Drehzahlsensor auslöst. Als Radsensorvorrichtung kann beispielsweise eine der oben beschriebenen Radsensorvorrichtungen eingesetzt werden.

Danach wird die Radsensorvorrichtung in einem Verfahrensschritt S11 direkt oder indirekt so an einer ersten Spannungsquelle des Fahrzeugs angebunden, dass eine erste Spannung zumindest an den ersten Drehzahlsensor bereitgestellt wird, wobei zusätzlich die Radsensorvorrichtung direkt oder indirekt so an einer zweiten Spannungsquelle des Fahrzeugs angebunden wird, dass eine zweite Spannung zumindest an den zweiten Drehzahlsensor bereitgestellt wird. Außerdem kann die Radsensorvorrichtung in dem Verfahrensschritt S11 oder in einem weiteren optionalen Verfahrensschritt S12 direkt oder indirekt so an der ersten Steuerelektronik des Fahrzeugs angebunden werden, dass bei einem Betrieb der Radsensorvorrichtung das mindestens eine erste Sensorsignal bezüglich der Änderung der mindestens einen ersten physikalischen Größe in dem ersten Drehzahlsensor und/oder der davon abgeleiteten ersten Information bezüglich des Drehverhaltens des Rads an die erste Steuerelektronik ausgegeben wird. Des Weiteren kann die Radsensorvorrichtung in dem Verfahrensschritt S11 oder in dem Verfahrensschritt S12 direkt oder indirekt so an der zweiten Steuerelektronik des Fahrzeugs angebunden werden, dass bei dem Betrieb der Radsensorvorrichtung das mindestens eine zweite Sensorsignal bezüglich der Änderung der mindestens einen zweiten physikalischen Größe in dem zweiten Drehzahlsensor und/oder der davon abgeleiteten zweiten Information bezüglich des Drehverhaltens des Rads an die zweite Steuerelektronik 42 ausgegeben wird.

Die Verfahrensschritte S10, S11 und S12 können in beliebiger Reihenfolge und/oder zumindest teilweise gleichzeitig ausgeführt werden.

## Patentansprüche

1. Radsensorvorrichtung für ein Fahrzeug mit:
einem Sensorgehäuse (10);
einem in dem Sensorgehäuse (10) angeordneten ersten Drehzahlsensor (14), welcher derart ausgelegt ist, dass nach einer Montage des Sensorgehäuses (10) mit dem ersten Drehzahlsensor (14) darin an dem Fahrzeug ein mit einem rotierenden Rad des Fahrzeugs mitrotierender Drehgeber eine Änderung mindestens einer ersten physikalischen Größe in dem ersten Drehzahlsensor (14) auslöst; und
einem zusätzlich zu dem ersten Drehzahlsensor (14) in dem Sensorgehäuse (10) angeordneten zweiten Drehzahlsensor (16), welcher derart ausgelegt ist, dass nach der Montage des Sensorgehäuses (10) mit dem ersten Drehzahlsensor (14) und dem zweiten Drehzahlsensor (16) darin an dem Fahrzeug der mit dem rotierenden Rad mitrotierende Drehgeber die Änderung der mindestens einen ersten physikalischen Größe in dem ersten Drehzahlsensor (14) und zusätzlich eine Änderung mindestens einer zweiten physikalischen Größe in dem zweiten Drehzahlsensor (16) auslöst;
wobei das Sensorgehäuse (10) der Radsensorvorrichtung eine vierpolige oder 2 x 2-polige Steckerkomponente (18) umfasst, und der erste Drehzahlsensor (14) und der zweite Drehzahlsensor (16) jeweils an der Steckerkomponente (18) angebunden sind;
**dadurch gekennzeichnet, dass**
die Steckerkomponente (18) direkt oder indirekt so an einer ersten Spannungsquelle (V1) des Fahrzeugs anbindbar ist, dass eine erste Spannung zumindest an den ersten Drehzahlsensor (14) bereitstellbar ist, und die Steckerkomponente (18) direkt oder indirekt so an einer zweiten Spannungsquelle (V2) des Fahrzeugs anbindbar ist, dass eine zweite Spannung zumindest an den zweiten Drehzahlsensor (16) bereitstellbar ist.

2. Radsensorvorrichtung nach Anspruch 1, wobei das Sensorgehäuse (10) mit dem eingesetzten ersten Drehzahlsensor (14) und dem eingesetzten zweiten Drehzahlsensor (16) benachbart zu dem Drehgeber in einer dem Rad zugeordneten Radlagervorrichtung an dem Fahrzeug montierbar ist.

3. Verfahren zum Montieren einer Radsensorvorrichtung nach Anspruch 1 oder 2 an einem Fahrzeug mit den Schritten:
Montieren der Radsensorvorrichtung derart an dem Fahrzeug, dass der mit dem rotierenden Rad mitrotierende Drehgeber die Änderung der mindestens einen ersten physikalischen Größe in dem ersten Drehzahlsensor (14) und zusätzlich die Änderung der mindestens einen zweiten physikalischen Größe in dem zweiten Drehzahlsensor (16) auslöst (S10);
**gekennzeichnet durch** den Schritt, dass
die Radsensorvorrichtung direkt oder indirekt so an einer ersten Spannungsquelle (V1) des Fahrzeugs angebunden wird, dass eine erste Spannung zumindest an den ersten Drehzahlsensor (14) bereitgestellt wird, und die Radsensorvorrichtung direkt oder indirekt so an einer zweiten Spannungsquelle (V2) des Fahrzeugs angebunden wird, dass eine zweite Spannung (V2) zumindest an den zweiten Drehzahlsensor (16) bereitgestellt wird (S11).

## Claims

1. Wheel-sensor device for a vehicle, with:
a sensor housing (10);
a first rotational-speed sensor (14) which has been arranged in the sensor housing (10) and which has been designed in such a manner that after a mounting of the sensor housing (10), with the first rotational-speed sensor (14) therein, on the vehicle a rotary transducer co-rotating with a rotating wheel of the vehicle triggers a change in at least one first physical quantity in the first rotational-speed sensor (14); and
a second rotational-speed sensor (16) which has been arranged in the sensor housing (10) in addition to the first rotational-speed sensor (14) and which has been designed in such a manner that after the mounting of the sensor housing (10), with the first rotational-speed sensor (14) and with the second rotational-speed sensor (16) therein, on the vehicle the rotary transducer co-rotating with the rotating wheel triggers the change in the at least one first physical quantity in the first rotational-speed sensor (14) and, in addition, a change in at least one second physical quantity in the second rotational-speed sensor (16);
wherein the sensor housing (10) of the wheel-sensor device includes a four-pin or 2-x-2-pin plug component (18) and the first rotational-speed sensor (14) and the second rotational-speed sensor (16) have each been connected to the plug component (18).
**characterized in that**
the plug component (18) can be directly or indirectly connected to a first voltage source (VI) of the vehicle in such a way that a first voltage can be made available at least to the first rotational-speed sensor (14), and the plug component (18) can be directly or indirectly connected to a second voltage source (V2) of the vehicle in such a way that a second voltage can be made available at least to the second rotational-speed sensor (16).

2. Wheel-sensor device according to Claim 1, wherein the sensor housing (10), with the inserted first rotational-speed sensor (14) and with the inserted second rotational-speed sensor (16), can be mounted on the vehicle adjacent to the rotary transducer in a wheel-bearing device assigned to the wheel.

3. Method for mounting a wheel-sensor device according to Claim 1 or 2 on a vehicle, with the following steps:
mounting the wheel-sensor device on the vehicle in such a manner that the rotary transducer co-rotating with the rotating wheel triggers (S10) the change in the at least one first physical quantity in the first rotational-speed sensor (14) and, in addition, the change in the at least one second physical quantity in the second rotational-speed sensor (16);
**characterized by** the following step where the wheel-sensor device is directly or indirectly connected to a first voltage source (V1) of the vehicle in such a way that a first voltage is made available at least to the first rotational-speed sensor (14), and the wheel-sensor device is directly or indirectly connected to a second voltage source (V2) of the vehicle in such a way that a second voltage (V2) is made available (S11) at least to the second rotational-speed sensor (16).

## Revendications

1. Dispositif capteur de roue pour un véhicule, comprenant :
un boîtier de capteur (10) ;
un premier capteur de vitesse de rotation (14) disposé dans le boîtier de capteur (10), lequel est conçu de telle sorte qu'après un montage du boîtier de capteur (10) dans lequel se trouve le premier capteur de vitesse de rotation (14) sur un véhicule, un codeur rotatif accompagnant la rotation d'une roue en rotation du véhicule déclenche une modification d'au moins une première grandeur physique dans le premier capteur de vitesse de rotation (14) ; et
un deuxième capteur de vitesse de rotation (16), disposé en complément du premier capteur de vitesse de rotation (14) dans le boîtier de capteur (10), lequel est conçu de telle sorte qu'après le montage du boîtier de capteur (10) dans lequel se trouvent le premier capteur de vitesse de rotation (14) et le deuxième capteur de vitesse de rotation (16) sur le véhicule, le codeur rotatif accompagnant la rotation de la roue en rotation déclenche la modification de l'au moins une première grandeur physique dans le premier capteur de vitesse de rotation (14) et en plus une modification d'au moins une deuxième grandeur physique dans le deuxième capteur de vitesse de rotation (16) ;
le boîtier de capteur (10) du dispositif capteur de roue comportant un composant à enfichage (18) quadripolaire ou à 2x2 pôles, et le premier capteur de vitesse de rotation (14) et le deuxième capteur de vitesse de rotation (16) sont respectivement reliés au composant à enfichage (18) ;
**caractérisé en ce que**
le composant à enfichage (18) peut être connecté directement ou indirectement à une première source de tension (V1) du véhicule de telle sorte qu'une première tension peut être fournie au moins au premier capteur de vitesse de rotation (14), et le composant à enfichage (18) peut être connecté directement ou indirectement à une deuxième source de tension (V2) du véhicule de telle sorte qu'une deuxième tension peut être fournie au moins au deuxième capteur de vitesse de rotation (16).

2. Dispositif capteur de roue selon la revendication 1, le boîtier de capteur (10) dans lequel est installé le premier capteur de vitesse de rotation (14) et installé le deuxième capteur de vitesse de rotation (16) pouvant être monté sur le véhicule adjacent au codeur rotatif dans un dispositif de palier de roue associé à la roue.

3. Procédé pour monter un dispositif capteur de roue selon la revendication 1 ou 2 sur un véhicule, comprenant les étapes suivantes :
montage du dispositif capteur de roue sur le véhicule de telle sorte que le codeur rotatif accompagnant la rotation de la roue en rotation déclenche la modification de l'au moins une première grandeur physique dans le premier capteur de vitesse de rotation (14) et en plus la modification de l'au moins une deuxième grandeur physique dans le deuxième capteur de vitesse de rotation (16) (S10) ;
**caractérisé par** l'étape selon laquelle
le dispositif capteur de roue est connecté directement ou indirectement à une première source de tension (V1) du véhicule de telle sorte qu'une première tension est fournie au moins au premier capteur de vitesse de rotation (14), et le dispositif capteur de roue est connecté directement ou indirectement à une deuxième source de tension (V2) du véhicule de telle sorte qu'une deuxième tension (V2) est fournie au moins au deuxième capteur de vitesse de rotation (16) (S11).
